# EUROPÄISCHE PATENTSCHRIFT

(11) **EP 2 511 765 B1**
(45) Veröffentlichungstag und Bekanntmachung des Hinweises auf die Patenterteilung: **03.04.2019**
(21) Anmeldenummer: 12005054.7
(22) Anmeldetag: 06.02.2008
(51) Int. Cl.: G03F 7/20, G02B 26/08, G05B 13/04, G01B 11/27, G01N 21/55, G01B 11/00, G01M 11/00

(54) **Regelvorrichtung zur Regelung einer flächigen Anordnung individuell ansteuerbarer Strahlablenkungselemente in einer mikrolithographischen Projektionsbelichtungsanlage**
Regulator for regulating a flat assembly of individually drivable beam deviation elements in a microlithographic projection exposure system
Régulateur pour réguler une disposition plane d'éléments déviateurs de faisceau commandés individuellement dans un système d'éclairage par projection microlithographique

(30) Priorität: 06.02.2007 DE 102007005875; 02.08.2007 DE 102007036245; 06.08.2007 US 954150 P; 21.12.2007 US 15999 P
(43) Veröffentlichungstag der Anmeldung: 17.10.2012
(62) Teilanmeldung aus: 08715697.2
(73) Patentinhaber: Carl Zeiss SMT GmbH, 73447 Oberkochen (DE)
(72) Erfinder: Xalter, Stefan, 73447 Oberkochen (DE); Kwan, Yim-Bun-Patrick, 73431 Aalen (DE); Major, András G., 73447 Oberkochen (DE); Maul, Manfred, 73434 Aalen (DE); Eisenmenger, Johannes, 89075 Ulm (DE); Fiolka, Damian, 73447 Oberkochen (DE); Horn, Jan, 70639 München (DE); Degünther, Markus, 73432 Aalen (DE); Bach, Florian, 73447 Oberkochen (DE); Patra, Michael, 73447 Oberkochen (DE); Wangler, Johannes, 89551 Königsbronn (DE); Layh, Michael, 87452 Altusried (DE)
(74) Vertreter: Ostertag & Partner Patentanwälte mbB

(56) Entgegenhaltungen:
- EP-A- 1 426 826
- US-A1- 2003 225 465
- US-A1- 2005 083 243

## Beschreibung

### HINTERGRUND DER ERFINDUNG

### 1. Gebiet der Erfindung

Die Erfindung betrifft Beleuchtungssysteme mikrolithographischer Projektionsbelichtungsanlagen, in denen flächige Anordnungen von Stahlablenkungselementen, z.B. Mikro-Spiegel-Arrays, zur variablen Ausleuchtung einer Pupillenfläche verwendet werden.

### 2. Beschreibung des Standes der Technik

In Beleuchtungssystemen mikrolithographischer Projektionsbelichtungsanlagen, welche bei der Herstellung von fein strukturierten Halbleiterbauelementen eingesetzt werden, kommen vermehrt flächige Anordnungen von Stahlablenkungselementen zum Einsatz, mit deren Hilfe das Projektionslicht sehr flexibel manipulierbar ist, um die Abbildungseigenschaften der mikrolithographischer Projektionsbelichtungsanlagen zu verbessern. Ein Beispiel hierfür sind sog. Multi-Mirror-Arrays (Vielfachspiegelanordnung), bei welchem eine Vielzahl von Mikrospiegeln in einem Feld, vorzugsweise in Reihen und Spalten, angeordnet sind. Die Mirkospiegel sind bewegbar und insbesondere über zwei senkrecht zueinander vorgesehene Achsen verkippbar, so dass ihre Oberflächennormale, ausgehend von einer Nullposition, in beliebige Richtungen verkippbar ist.

Dies wird dazu genutzt, um in Beleuchtungssystemen die Beleuchtungseinstellungen variabel verändern zu können. Beispiele hierfür sind in der WO 2005/026 843 A2, der EP 1 426 826 A2 sowie der EP 1 262 836 A1 gegeben. Weiterhin werden Multi-Mirror-Arrays auch als reflektives Retikel einer Belichtungsanlage für die Mikrolithographie eingesetzt (WO 2005/096098 A2).

Für derartige Komponenten ist es wesentlich, die genaue Kippstellung der einzelnen Spiegelelemente zu kennen, um exakte Positionen einstellen zu können, welche maßgeblich die entsprechenden Abbildungseigenschaften beeinflussen.

So ist beispielsweise in der US 6 421 573 B1 eine Vorrichtung offenbart, bei der eine Hilfslichtquelle zur Bestimmung der Verkippungswinkel eines einzigen Scannerspiegels verwendet wird, wobei mit dem Scannerspiegel das Licht eines UV Lasers ausgelenkt wird, um Muster zu schreiben.

Aus der US 6 965 119 B2 ist ein Verfahren zur Justierung entsprechender Spiegelelemente von Multi-Mirror-Arrays bekannt, bei welchem ein Teil des Belichtungsstrahls, d.h. des Projektionslichts, aus dem Strahlengang ausgekoppelt wird, um durch Intensitätsmessungen eine Justierung der Spiegelelemente vornehmen zu können. Diese Vorgehensweise hat allerdings den Nachteil, dass durch die Auskopplung des Nutzlichts Intensitätsverluste auftreten, die im Hinblick auf möglichst kurze Belichtungszeiten unerwünscht sind.

Um Beeinträchtigungen durch Intensitätsverluste zu vermeiden, ist es nach dem Stand der Technik daher beispielsweise möglich, eine Überprüfung und Justierung der Ausrichtung von Spiegelelementen eines Multi-Mirror-Arrays in Zeiten vorzunehmen, in denen das Objektiv nicht genutzt wird. Allerdings sind hier unter Umständen längere Stillstandszeiten zur Überprüfung der Spiegelelemente erforderlich, die nicht gewünscht sind und einen effektiven Betrieb eines entsprechenden Objektivs beeinträchtigen.

Eine Bestimmung der Verdreh- bzw. Kippwinkel der Spiegelelemente eines Multi-Mirror-Arrays durch entsprechende Sensoren an den Aktuatoren für die Bewegung der Spiegelelemente ist aufgrund der Vielzahl der Spiegelelemente sehr aufwendig und führt dazu, dass durch den erforderlichen Bauraum der Sensoren die Anordnung der Strahlablenkungselemente in Form eines Multi-Mirror-Arrays sehr voluminös wird.

Aus der US 2003/0225465 A1 ist ein Verfahren zur Steuerung eines Mikrospiegels bekannt, bei dem ein Zustandsschätzer verwendet wird.

Die US 2005/0083243 A1 betrifft ebenfalls einen Zustandsschätzer, jedoch im Zusammenhang mit der Verringerung von Overlay-Fehlern bei der Herstellung von Halbleiterbauelementen.

### AUFGABE DER ERFINDUNG

Es ist Aufgabe der vorliegenden Erfindung, eine Regelvorrichtung bereitzustellen, mit der sich eine flächige Anordnung von individuell ansteuerbaren Strahlablenkungselementen so regeln lässt, dass die gewünschte Ablenkung mit hoher Genauigkeit eingestellt wird.

### ZUSAMMENFASSUNG DER ERFINDUNG

Diese Aufgabe wird gelöst durch eine Regelvorrichtung mit den Merkmalen des Anspruchs 1. Vorteilhafte Ausgestaltungen sind Gegenstand der abhängigen Ansprüche.

Zur aktiven Steuerung bzw. Regelung von manipulierbaren Strahlablenkungselementen, wie beispielsweise Mikrospiegeln eines Multi-Mirror-Arrays, können Werte eingesetzt werden, die in der folgenden Weise ermittelt werden:
Zusätzlich zu dem Projektionslicht des Beleuchtungssystems, dem die flächige Anordnungen von Stahlablenkungselementen ausgesetzt ist, wird mindestens ein Messlichtbündel aus einer Messbeleuchtungseinrichtung auf die zu untersuchende Strahlablenkungselemente gerichtet, so dass von einer Detektoreinrichtung die Ablenkung des Messlichtbündels aufgrund des Strahlablenkungselements erfasst werden kann. Nimmt man dabei an, dass die Ablenkung des Messlichtbündels durch das Strahlablenkungselemente und die Ablenkung des auf diesem einfallenden Projektionslichts miteinander korrelieren, so kann letztlich über diese separate Messeinrichtung die Ablenkung des Projektionslichts oder die Änderung einer solchen gegenüber einer vorgegebenen Einstellung ermittelt werden. Durch das zusätzliche Vorsehen einer separaten Messbeleuchtungseinrichtung, die das entsprechenden Messlichtbündel erzeugt, ist es möglich, auf die Auskopplung von Nutzlicht aus dem Projektionslicht zu verzichten, wobei gleichzeitig eine kontinuierlich, während der Nutzung der mikrolithographischen Belichtungsanlage ablaufende Überprüfung und Bestimmung von Ablenkungsänderungen des zu untersuchenden optischen Elements ermöglicht wird. Hierzu ist lediglich erforderlich, dass die Einstrahlrichtung des oder der Messstrahlbündel unterschiedlich zu der Einstrahlrichtung des oder der Projektionslichtbündel ist, so dass keine gegenseitige Beeinträchtigung stattfindet.

Insbesondere kann mit einem derartigen Vorgehen die Winkeländerung der Oberflächennormale einer zu untersuchenden Spiegeloberfläche eines optischen Elements bzw. die Ausrichtung einer entsprechenden Spiegeloberfläche überwacht und untersucht werden.

Die Einstrahlrichtung des Messstrahlbündels kann sich sowohl im Einfallswinkel bzgl. der zu untersuchenden Oberfläche des optischen Elements als auch einer azimutalen Einfallsrichtung unterscheiden. Unter azimutaler Einfallsrichtung ist hierbei die Verdrehung der Einfallsebene des entsprechenden Strahls gegenüber einer vorgegebenen Ebene, wie z. B. einer in Nord-Süd-Ausrichtung angeordneten Einfallsebene zu verstehen.

Wenn sich die Einfallsrichtung des Messlichtbündels und des Projektionslichts nicht in der azimutalen Einfallsrichtung unterscheiden, müssen sie sich zumindest im Einfallswinkel unterscheiden, um eine gegenseitige Beeinträchtigung zu vermeiden und eine Erfassung des von der Spiegeloberfläche reflektierten Messlichtbündels durch ein Detektorsystem zu ermöglichen.

Unterscheiden sich die Einstrahlrichtung des Messlichtbündels und die Einstrahlrichtung des oder der Projektionslichtbündel in der azimutalen Einfallsrichtung, so kann zusätzlich eine Unterscheidung im Einfallswinkel des zu untersuchenden optischen Elementes vorliegen. Das ist jedoch nicht erforderlich.

Bevorzugt ist eine Unterscheidung der Einstrahlrichtung des Messlichtbündels von der Einstrahlrichtung des oder der Projektionslichtbündel in der azimutalen Einfallsrichtung, wobei Drehwinkel im Bereich von mehr als 30°, vorzugsweise mehr als 60° und insbesondere ein gegenseitiger Drehwinkel von 90° um die Oberflächennormale des zu untersuchenden optischen Elements möglich sind. Bei einer 90°-Anordnung zwischen der Einfallsebene des Messlichts und der Einfallsebene des Projektionslichts ist besonders viel Bauraum für die Anordnung der Messbeleuchtungseinrichtung und einer entsprechend angeordneten Detektoreinrichtung gegeben.

Um eine definierte Beleuchtung des zu untersuchenden optischen Elements mit Messlicht zu gewährleisten und ebenso eine definierte Erfassung der Änderungen des Messlichts durch die Wechselwirkung mit der Oberfläche des optischen Elementes zu ermöglichen, kann zwischen der Beleuchtungsquelle und dem zu untersuchenden optischen Element einerseits und/oder dem zu untersuchenden optischen Element und der entsprechenden Detektoreinrichtung andererseits jeweils ein optisches System vorgesehen sein.

Das Messlicht kann beliebige geeignete Wellenlängen aufweisen und sowohl im sichtbaren als auch im nicht sichtbaren Bereich liegen. Allgemein wird unter Licht jede elektromagnetische Strahlung verstanden.

Das optische System für die Messbeleuchtung kann einen oder eine Vielzahl von Kollimatoren, insbesondere in Form eines Lochblechs mit einem vorgeschalteten Mikrolinsenfeld, umfassen, so dass entsprechende kollimierte Messlichtbündel erzeugt werden.

Diese kollimierten Messlichtbündel werden an der zu untersuchenden Oberfläche reflektiert und können durch entsprechend vor Positionssensoren der Detektoreinrichtung angeordneten Sammellinsen, insbesondere einem Linsenfeld aus Mikrosammellinsen als Fernfeldbeugungsbild bzw. Fourier-Transformierte in die Brennebene der entsprechenden Sammellinsen abgebildet werden. Dort in der Brennebene können entsprechende Positionssensoren, beispielsweise 4-Quadranten-Detektoren oder zweidimensionale positionssensitive Sensoren vorgesehen sein, die eine Abweichung des auf den Sensor eintreffenden Lichtkegels von einer Nullposition, die einer bestimmten Ausrichtung der Oberfläche des zu untersuchenden optischen Elements entspricht, feststellen.

Um zusätzlich Bauraum zu gewinnen, kann zwischen zu untersuchendem optischen Element und der Detektoreinrichtung eine zusätzliche Optik vorgesehen werden, die es ermöglicht, die Detektoreinrichtung weit entfernt von dem zu untersuchenden optischen Element anzuordnen. Darüber hinaus kann eine Optik vorgesehen werden, welche eine variable Anordnung der Detektoreinrichtung bei gleichzeitiger, scharfer Abbildung eines Oberflächenbereichs des zu untersuchenden optischen Elements ermöglicht. Dazu wird die entsprechende abbildende Optik derart gestaltet, dass der zu untersuchende Oberflächenbereich des optischen Elements unter Einhaltung der Scheimpflugbedingungen auf die den Positionssensoren zugeordneten optischen Linsen abgebildet wird.

Gleichzeitig muss die entsprechende Optik sicherstellen, dass die Einfallsrichtung der Messlichtbündel auf die Detektorsammellinsen der Detektoreinrichtung der Ausrichtung der zugeordneten Oberflächenbereiche des optischen Elements bzw. der Verkippungswinkel der Spiegelelemente eines Multi-Mirror-Arrays entspricht. Dies kann beispielsweise durch eine Relais-Optik mit zwei Sammellinsen gewährleistet werden.

### KURZE BESCHREIBUNG DER ZEICHUNGEN

Weitere Vorteile und Merkmale der vorliegenden Erfindung werden bei der nachfolgenden detaillierten Beschreibung zweier Ausführungsbeispiele anhand der beigefügten Zeichnungen deutlich. Die Zeichnungen zeigen hierbei in rein schematischer Weise in
- Figur 1: eine stark vereinfachte perspektivische Darstellung einer mikrolithographischen Projektionsbelichtungsanlage;
- Figur 2: eine Seitenansicht eines zu untersuchenden optischen Elementes in Form eines Multi-Mirror-Arrays (Mehrfachspiegelanordnung);
- Figur 3: eine Draufsicht auf das zu untersuchende optische Element aus Figur 1 mit einer Darstellung der Messanordnung;
- Figur 4: eine perspektivische Darstellung der Messanordnung;
- Figur 5: eine Seitenansicht eines ersten Ausführungsbeispiels der Messeinrichtung;
- Figur 6: eine Seitenansicht eines zweiten Ausführungsbeispiels einer Messeinrichtung;
- Figur 7: eine Seitenansicht eines in einem Gehäuse gekapselten Multi-Mirror-Arrays;
- Figur 8: eine perspektivische Darstellung eines Ausführungsbeispiels, bei dem die Verkippung der einzelnen Spiegelelemente eines Multi-Mirror-Arrays mit Hilfe einer Kamera erfasst werden;
- Figur 9: eine Darstellung eines Musters, das zur Verwendung bei dem in Figur 8 dargestellten Ausführungsbeispiels geeignet ist;
- Figur 10: eine Seitenansicht eines Beleuchtungssystem mit einem Multi-Mirror-Array;
- Figur 11: eine Zusammenfassung einer Kalibriereinrichtung, in der zum einen eine Kalibrierplatte zum anderen ein Intensitätsverlauf während des Bewegens eines Spiegelelements und dem daraus bestimmten Zusammenhang zwischen Spiegelelementwinkel und Systemwinkel dargestellt ist;
- Figur 12: ein Schema eines erfindungsgemäßen Regelkreises, der zur Überwachung und Steuerung von Strahlablenkungselementen verwendet werden kann;
- Figur 13: ein Detailschema des in Figur 12 gezeigten Regelalgorithmus; und in
- Figur 14: ein Aufbauschema einer Messeinrichtung, die ein Frequenzmultiplexverfahren anwendet.

### BESCHREIBUNG BEVORZUGTER AUSFÜHRUNGSBEISPIELE

### 1. Aufbau einer Projektionsbelichtungsanlage

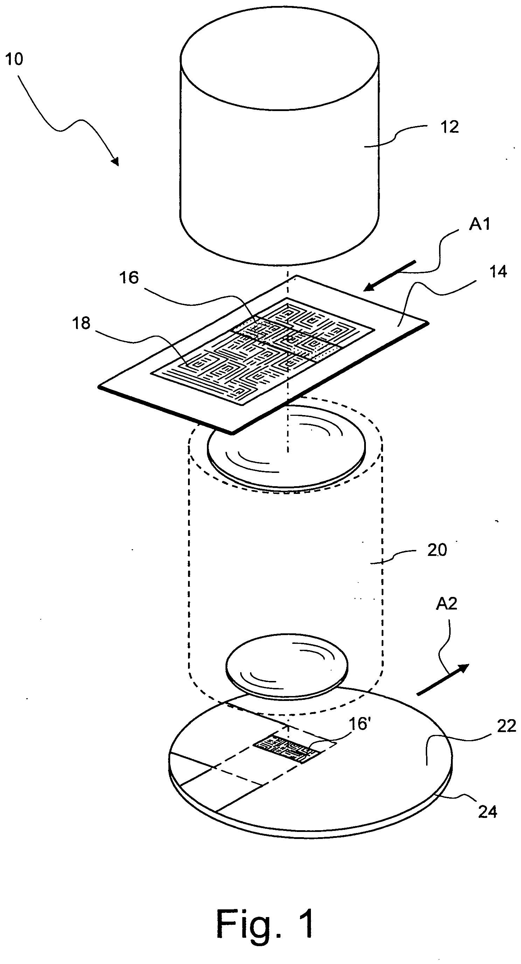

Die Figur 1 zeigt in einer stark schematisierten perspektivischen Darstellung eine Projektionsbelichtungsanlage 10, die für die lithographische Herstellung mikrostrukturierter Bauteile geeignet ist. Die Projektionsbelichtungsanlage 10 enthält ein Beleuchtungssystem 12, das auf einer in der sogenannten Maskenebene angeordneten Maske 14 ein schmales, in dem dargestellten Ausführungsbeispiel rechteckiges Beleuchtungsfeld 16 ausleuchtet. Das Beleuchtungssystem 12 enthält eine Lichtquelle, mit der Projektionslicht erzeugbar ist. Gebräuchliche Lichtquellen sind beispielsweise Excimer-Laser mit den Lasermedien KrF, ArF oder F₂, mit denen sich Projektionslicht mit den Wellenlängen 248 nm, 193 nm bzw. 157 nm erzeugen lassen.

Innerhalb des Beleuchtungsfeldes 16 liegende Strukturen 18 auf der Maske 14 werden mit Hilfe eines Projektionsobjektivs 20 auf eine lichtempfindliche Schicht 22 abgebildet. Die lichtempfindliche Schicht 22, bei der es sich zum Beispiel um einen Fotolack handeln kann, ist auf einem Wafer 24 oder einem anderen geeigneten Substrat aufgebracht und befindet sich in der Bildebene des Projektionsobjektivs 20, die auch Waferebene genannt wird. Da das Projektionsobjektiv 20 im Allgemeinen einen Abbildungsmaßstab |β| < 1 hat, werden die innerhalb des Beleuchtungsfeldes 16 liegenden Strukturen 18 verkleinert als 16' abgebildet.

Die Leistungsfähigkeit einer solchen Projektionsbelichtungsanlage wird nicht nur durch das Projektionsobjektiv 20, sondern auch durch das Beleuchtungssystem 12, das die Maske 14 beleuchtet, bestimmt. Neben der Intensität der auf die Maske 14 auftreffenden Lichtbündel hat auch deren Beleuchtungswinkelverteilung einen Einfluss auf die Qualität, mit der die in der Maske 14 enthaltenen Strukturen 18 auf die lichtempfindliche Schicht 22 abgebildet werden. Je nach Richtung und Größe der abzubildenden Strukturen 18 haben sich andere Beleuchtungswinkelverteilungen als vorteilhaft herausgestellt. Da mit der Projektionsbelichtungsanlage 10 unterschiedliche Masken 14 abgebildet werden sollen, wäre ein Beleuchtungssystem ideal, mit dem sich auf einfache Weise verschiedene Beleuchtungswinkelverteilungen einstellen lassen. Dazu ist es erforderlich, eine Pupillenfläche des Beleuchtungssystems 12, welche die Beleuchtungswinkelverteilung maßgeblich bestimmt, mittels eines ansteuerbaren optischen Elements möglichst variabel auszuleuchten.

### 2. Messprinzip

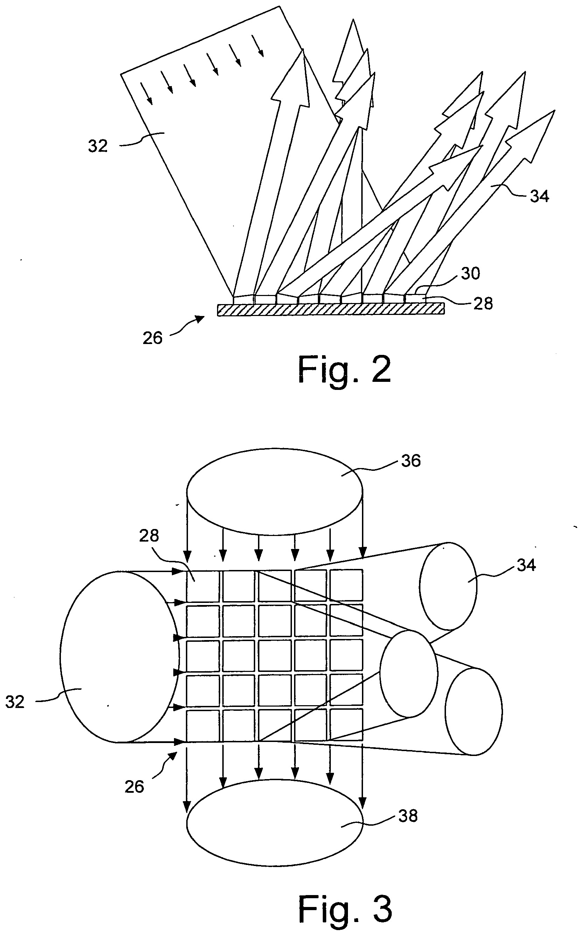

Die Figur 2 zeigt in einer schematischen Seitenansicht ein Beispiel eines solchen optischen Elementes, für dessen Überwachung und Steuerung die Vorrichtung eingesetzt werden können. Bei dem optischen Element der Figur 1 handelt es sich um ein sog. Multi-Mirror-Array (Mehrfachspiegelanordnung) 26, das eine Vielzahl von kleinen Spiegelelementen 28 umfasst, welche bewegbar, und zwar insbesondere kippbar, angeordnet sind, so dass die Spiegelflächen 30 der beispielsweise in Reihen und Spalten nebeneinander angeordneten Spiegelelemente 28 unterschiedlich ausgerichtet werden können. Dadurch kann einfallendes Projektionslicht 32 durch Reflexion an den Spiegelflächen 30 in eine Vielzahl von reflektierten Projektionslichtbündeln 34 aufgeteilt werden, deren Ausbreitungsrichtung durch Verkippen der Spiegelflächen 30 innerhalb vorgegebener Grenzen frei wählbar sind. In manchen Systemen wird das einfallende Projektionslicht 32 vor dem Auftreffen auf die Spiegelflächen 30 unter Verwendung von Mikrolinsen-Arrays in einzelne Lichtbündel unterteilt und auf die Spiegelelemente 28 fokussiert.

Ein derartiges Multi-Mirror-Array 26 kann dann in einem Beleuchtungssystem 12 einer mikrolithographischen Projektionsbelichtungsanlage 10 zur variablen Ausleuchtung der Pupillenfläche, kurz auch Pupillenausleuchtung genannt, eingesetzt werden. Da kleinste Veränderungen der Kippwinkel der Spiegelelemente 28 große Auswirkungen auf die Pupillenausleuchtung und damit auf die Beleuchtungswinkelverteilung auf der Maske 14 haben, ist vorgesehen, die exakten Winkelpositionen der Spiegelflächen 30 zu ermitteln.

Wie aus der Figur 3 ersichtlich ist, wird zusätzlich zu dem einfallenden Projektionslicht 32, d.h. dem zur Beleuchtung der Maske 14 verwendeten Nutzlicht des Beleuchtungssystems 12, eine zusätzliche Messbeleuchtungseinrichtung vorgesehen, die Messlicht 36 auf die Spiegelelemente 28 des Multi-Mirror-Arrays 26 richtet. Je nach Ausführungsbeispiel kann die Messbeleuchtung hierzu ein oder mehrere Messlichtbündel erzeugen, die entweder scannend, d.h. nacheinander, oder für einige oder alle Spiegelelemente 28 gleichzeitig auf die Spiegelelemente 28 gerichtet werden. Da die Einfallsrichtungen der Messlichtbündel bekannt sind, kann durch Messung der Ausfallsrichtungen der reflektierten Messlichtbündel auf die Ausrichtung der reflektierenden Spiegeloberflächen 30 geschlossen werden. Dabei wird ausgenutzt, dass die Ablenkung des Projektionslichts 32 mit der Ablenkung des Messlichts 36 korreliert ist. Das reflektierte Messlicht 38 enthält folglich Informationen über den Kippzustand und somit über die Ausrichtung der Spiegelelemente 28. Bei der in Figur 3 dargestellten Messanordnung wird das Messlicht 36 in einer Ebene auf die Spiegelelemente 28 gerichtet, welche um 90° um die Oberflächennormale der reflektierenden Spiegeloberflächen 30 gegenüber der Einfallsebene des einfallenden Projektionslichts 32 verdreht ist.

Damit ist eine kontinuierliche Messung der Ausrichtung der Spiegelelemente 28 auch während des Betriebs des Beleuchtungssystems 12 möglich. Ausfallzeiten der Projektionsbelichtungsanlage 10 für die Bestimmung der Ausrichtung der Spiegelelemente 28 fallen somit nicht an. Da für die Bestimmung der Ausrichtung der Spiegelelemente 28 kein Anteil des einfallenden Projektionslichts 32 verwendet wird, entsteht kein Lichtverlust, welcher den Durchsatz der Projektionsbelichtungsanlage 10 verringern könnte.

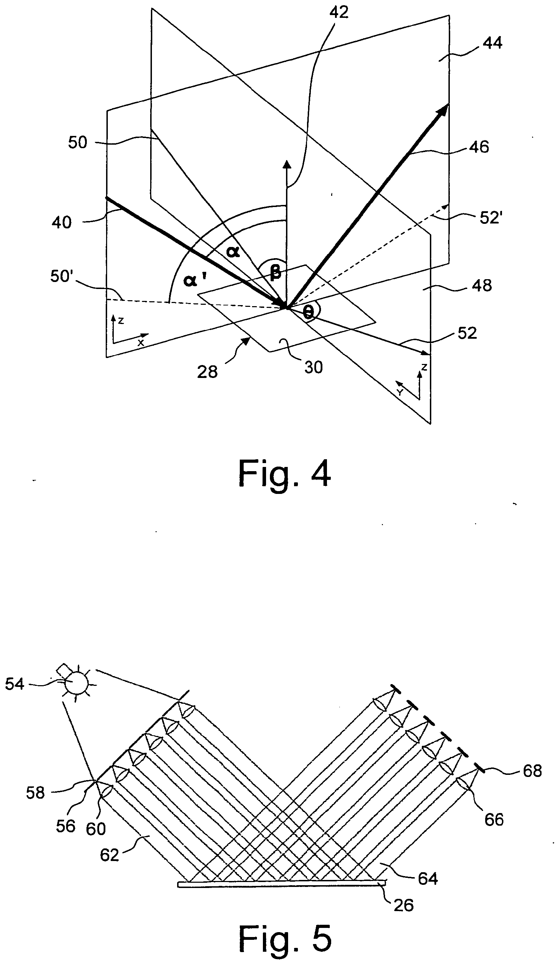

Die Figur 4 zeigt in einer perspektivischen Darstellung Einzelheiten des Messprinzips. Wie aus der Figur 4 zu entnehmen ist, trifft das einfallende Projektionslicht 32 unter einem bestimmten Einfallswinkel α entlang einer Einfallsrichtung 40 auf die Spiegeloberfläche 30 eines Spiegelelements 28. Die Einfallsrichtung 40 des einfallenden Projektionslichts 32 spannt dabei mit der Oberflächennormalen 42 der Spiegeloberfläche 30 die Einfallsebene (xz-Ebene) 44 auf, in der gemäß dem Reflexionsgesetz auch die Ausfallsrichtung 46 des reflektierten Projektionslichtbündels 34 liegt.

Gemäß der Darstellung der Figur 3 wird in einer yz-Ebene 48, welche azimutal um die Oberflächennormale 42 um einen Drehwinkel θ in der Größenordnung von 90° gegenüber der Einfallsebene 40 des Projektionslichts 32 verdreht ist, einfallendes Messlicht 36 entlang einer Einfallsrichtung 50 auf die Spiegeloberfläche 28 gerichtet, das nach Reflexion an der Spiegeloberfläche 28 als reflektiertes Messlicht 38 entlang einer Ausfallsrichtung 52 in Richtung einer Detektoreinrichtung abgestrahlt wird. Bei dieser Lösung unterscheidet sich somit die Einfallsrichtung 50 des Messlichts 36 von der Einfallsrichtung 40 des Projektionslichts 32 zumindest in der azimutalen Einfallsrichtung, also in der Einfallsebene. Zusätzlich oder alternativ kann das Messlicht 36 auch unter einem anderen Einfallswinkel auf die Spiegeloberfläche 30 auftreffen als das Projektionslicht 32.

Dies ist beispielsweise für eine Einfallsrichtung 50' des Messlichts 36 dargestellt, die in der gleichen Einfallsebene 44 liegt, in der das Projektionslicht 32 auf das Spiegelelement 28 trifft, jedoch einen Einfallswinkel α' zur Oberflächennormalen 42 bildet, der sich von dem Einfallswinkel α der Einfallsrichtung 40 des Projektionslichts 32 unterscheidet. Daher wird auch das reflektierte Messlicht 38 entlang einer Ausfallsrichtung 52' unter einem anderen Winkel von dem Spiegelelement 28 abgestrahlt als das Projektionslicht 32.

### 3. Ausführungsbeispiele für Messeinrichtungen

Die Figur 5 zeigt eine Realisierung einer Messeinrichtung, bei der eine Lichtquelle 54 der Messbeleuchtungseinrichtung Licht auf ein Lochblech 56 richtet. Durch das Lochblech 56 wird eine Vielzahl von Punktlichtquellen 58 erzeugt. Nachgeordnete Kollimator-Sammellinsen 60, die in der Art eines Mikrolinsen-Arrays zusammengefasst sind, bilden jeweils einen Kollimator und erzeugen auf diese Weise aus dem von der zugeordneten Punktlichtquelle 58 erzeugten Licht ein kollimiertes Messlichtbündel 62. Die von den unterschiedlichen Kollimator-Sammellinsen 60 erzeugten Messlichtbündel 62 verlaufen dabei vorzugsweise parallel zueinander.

Die kollimierten Messlichtbündel 62 treffen auf die zu untersuchenden Spiegeloberflächen 28 des Multi-Mirror-Arrays 26 und werden dort in Abhängigkeit von der Ausrichtung der Spiegeloberflächen 28 in unterschiedliche Richtungen abgelenkt. Die reflektierten Messlichtbündel 64 treffen auf ein Mikrolinsen-Array, das eine Vielzahl von Detektor-Sammellinsen 66 enthält, in deren hinterer Brennebene Positionssensoren 68 angeordnet sind. Durch diese Anordnung stehen die Winkel, mit welchen die reflektierten Messlichtbündel 64 auf die Detektor-Sammellinsen 66 auftreffen, in einer Fourier-Beziehung zu der Position der Brennpunkte auf den Positionssensoren 68, auf welche die reflektierten Messlichtbündel 64 fokussiert werden.

Da diese Winkel der reflektierten Messlichtbündel 64 entsprechend dem oben erläuterten Reflexionsgesetz von der Ausrichtung der jeweils zugeordneten Spiegelelemente 28 des Multi-Mirror-Arrays 26 abhängen, kann somit durch Erfassen der Position der Brennpunkte auf den Positionssensoren 68 die Ausrichtung der Spiegelelemente 28 bestimmt werden. Als Positionssensoren 68 können beispielsweise 4-Quadranten-Detektoren oder zweidimensionale positionssensitive Sensoren eingesetzt werden. Auf diese Weise kann beispielsweise ein Winkelbereich von ±2 bis ±3° einer Verkippung der Spiegelelemente 28 gegenüber einer vorbestimmten Oberflächenausrichtung ermittelt werden.

Falls die Spiegeloberflächen 30 der Spiegelelemente 28 eine Krümmung aufweisen, so können Messlichtbündel 62 auf unterschiedliche Punkte desselben Spiegelelements 28 gerichtet werden. Dies kann gleichzeitig oder auch nacheinander, in einer Art Scanverfahren sogar mit demselben Messlichtbündel 62, geschehen. Aus den unterschiedlichen Ablenkungen der Messlichtbündel 62 für die unterschiedlichen Punkte der Spiegeloberfläche 30 kann dann die Krümmung bestimmt werden. Eine andere Möglichkeit zur Bestimmung der Krümmung besteht darin, beispielsweise durch Bestimmung des Brennpunktdurchmessers eines von einer gekrümmten Spiegeloberfläche 30 kommenden Messlichtbündels 62 auf dem Positionssensor 68, dessen Divergenz und damit die Krümmung der Spiegeloberfläche 30 zu bestimmen, wenn man davon ausgeht, dass die Divergenz des einfallenden Messlichts 36 bekannt ist.

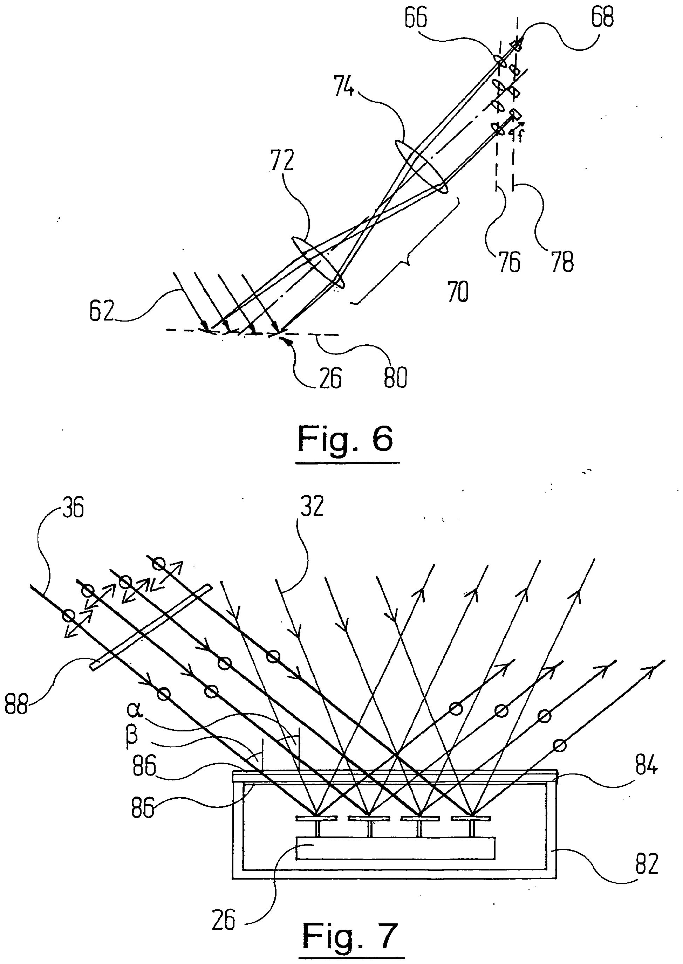

Um die Detektoreinheit mit den Positionssensoren 68 und das vorgeschaltete Mirkolinsen-Array mit den Detektor-Sammellinsen 66 in einer gewissen Entfernung von dem Multi-Mirror-Arrays 26 anordnen zu können, ist nach einem weiterem Ausführungsbeispiel gemäß der Figur 6 eine zusätzliche Relais-Optik 70 vorgesehen. Die Relais-Optik 70, die rein schematisch mit zwei Sammellinsen 72 und 74 dargestellt ist, bildet das Multi-Mirror-Array 26 auf die Anordnung der Detektor-Sammellinsen 66 ab. Durch die Relais-Optik 70 wird ein größerer Abstand zu den Spiegeloberflächen 30 ermöglicht, ohne dass der zu untersuchende Winkelbereich eingeschränkt wird. Die Relais-Optik 70 entkoppelt somit den detektierbaren Winkelbereich der Verkippung vom Abstand der Positionssensoren 68 vom Multi-Mirror-Array 26. Auf diese Weise kann die Messeinrichtung außerhalb des Strahlengangs des Beleuchtungssystems 12 angeordnet werden, wo genügend Bauraum zur Verfügung steht.

Bei dem in der Figur 6 gezeigten Ausführungsbeispiel sind die Positionssensoren 68 und das Mikrolinsen-Array mit den Detektor-Sammellinsen 66 in Ebenen 76 und 78 angeordnet, die bezüglich einer Ebene 80, in welcher das Multi-Mirror-Array 26 angeordnet ist, die Scheimpflugbedingung erfüllen. Die Scheimpflugbedingung ist erfüllt, wenn sich die Hauptebene der Relais-Optik 70 mit der Ebene 76 der Detektor-Sammellinsen 66 und der Ebene 80, in welcher sich die Spiegelelemente 30 des Multi-Mirror-Arrays 26 erstrecken, in einer Achse schneiden. Bei einer solchen Anordnung kann die geneigt zur optischen Achse angeordnete Ebene 80, in der sich die Spiegelelemente 30 erstrecken, scharf auf die Detektor-Sammellinsen 66 des Mikrolinsen-Arrays abgebildet werden.

Ähnlich wie bei dem Ausführungsbeispiel der Figur 5 verändert sich die Position des auf dem Positionssensor 68 entstehenden Brennpunkts in Abhängigkeit von dem Einfallswinkel, mit dem das zugeordnete Messlichtbündel 64 auf die Detektorsammellinse 66 trifft. Dieser Einfallswinkel ist jedoch aufgrund der Abbildung durch die Relais-Optik 70 wiederum proportional zum Kippwinkel der zugeordneten Spiegeloberfläche, deren Ausrichtung gemessen werden soll. Dadurch ist es auch hier möglich, durch Abweichungen des Brennpunkts von einer Nullposition, die einer vorbestimmten Ausrichtung der Spiegeloberfläche 30 entspricht, im Positionssensor 68 auf den Kippwinkel der betreffenden Spiegeloberfläche 30 zurückzuschließen.

Dieser Ansatz ermöglicht es, die Ausrichtung der Spiegelelemente 28 des Multi-Mirror-Array 26 während des Betriebs der Projektionsbelichtungsanlage zu bestimmen. Bei Abweichungen der gemessenen Ausrichtung von einer Soll-Ausrichtung kann das betreffende Spiegelelement 28 solange nachgestellt werden, bis die gewünschte Soll-Ausrichtung erreicht ist. Dies ist Voraussetzung für eine aktive Steuerung oder Regelung der Spiegelelemente 28, wie sie weiter untern näher erläutert wird.

### 4. Kapselung des Multi-Mirror-Arrays

Figur 7 zeigt eine stark vereinfachte Darstellung eines Multi-Mirror-Arrays 26, das, zum Schutz gegen äußere Einflüsse wie z.B. Druck- oder Temperaturschwankungen, innerhalb des Beleuchtungssystems 12 in einem Gehäuse 82 gekapselt ist. Das Gehäuse 82 weist dabei ein transparentes Fenster 84 auf, durch welches das einfallende Projektionslicht 32 und das Messlicht 36 auf die einzelnen Spiegelelemente 28 des Multi-Mirror-Arrays 26 fallen kann. Nachdem die einzelnen Strahlenbündel entsprechend der Ausrichtung der Spiegelelemente 28 abgelenkt wurden, durchtreten sie das transparente Fenster 84 des Gehäuses 82 in der Gegenrichtung.

Zur Verminderung unerwünschter Reflexe und damit verbundenem Intensitätsverluste trägt das transparente Fenster 84 eine oder mehrere Antireflexbeschichtungen 86, die üblicherweise auf die Wellenlänge des hindurchtretenden Lichts und die auftretenden Winkel angepasst sind. Im Ausführungsbeispiel ist die Antireflexbeschichtung 86 daher so ausgebildet, dass das einfallende Projektionslicht 32, das unter dem Winkel α einfällt, das transparente Fenster 84 mit möglichst wenig Intensitätsverlust passieren kann.

Damit auch das einfallende Messlicht 36, das meist eine andere Wellenlänge hat und unter Umständen, wie oben erläutert, unter einem anderen Winkel β auf das Multi-Mirror-Array 26 fällt, möglichst ohne störende Reflexe zu verursachen, durch das transparente Fenster 84 treten kann, ist ein Polarisator 88 in den Strahlengang des einfallenden Messlichts 36 eingeführt. Die Polarisationsrichtung des einfallenden Messlichts 36 ist dabei so gewählt, dass das Messlicht 36 in Bezug auf die Einfallsebene des Messlichts 36 auf das transparente Fenster 84 im Wesentlichen p-polarisiert ist.

Ferner ist die Messbeleuchtungseinrichtung so angeordnet, dass der Einfallswinkel β des einfallenden Messlichts 36 zumindest annähernd gleich dem Brewsterwinkel ist. Trifft nämlich Licht unter dem Brewsterwinkel auf die Grenzfläche zweier optischer Medien, so beinhaltet das reflektierte Licht nur die s-polarisierte Komponente des einfallenden Lichts. Da im vorliegenden Fall das einfallende Messlicht 36 vollständig p-polarisiert ist und somit keine s-polarisierte Komponente enthält, die reflektiert werden könnte, wird kein Licht an dem transparenten Fenster 84 reflektiert. Somit kann das einfallende Messlicht 36 nahezu verlustfrei durch das transparent Fenster 84 hindurchtreten, obwohl die Antireflexbeschichtungen 86 nur für das einfallende Projektionslicht 32, nicht aber für das einfallende Messlicht 36 optimiert sind. Es ist jedoch vorteilhaft, wenn die Wellenlänge des einfallenden Messlichts 36 größer ist als die Dicke der Antireflexbeschichtungen 86, die für das einfallende Projektionslicht 32 optimiert wurden, da in diesem Fall die Antireflexbeschichtungen 86 auf das einfallende Messlicht 36 keinerlei Wirkung haben.

Nach der Reflexion an den Spiegelelementen 28 des Multi-Mirror-Arrays 26 entsprechen die Winkel der austretenden Strahlenbündel zwar nicht mehr dem Brewsterwinkel, sind aber durch die geringen Kippwinkel von ±2-3° der Spiegelelemente 28 nahe des Brewsterwinkel, so dass auch bei den austretenden Strahlenbündeln eine Verminderung der unerwünschten Reflexionen zu beobachten ist.

### 5. Bestimmen der Ausrichtung durch Mustererkennung

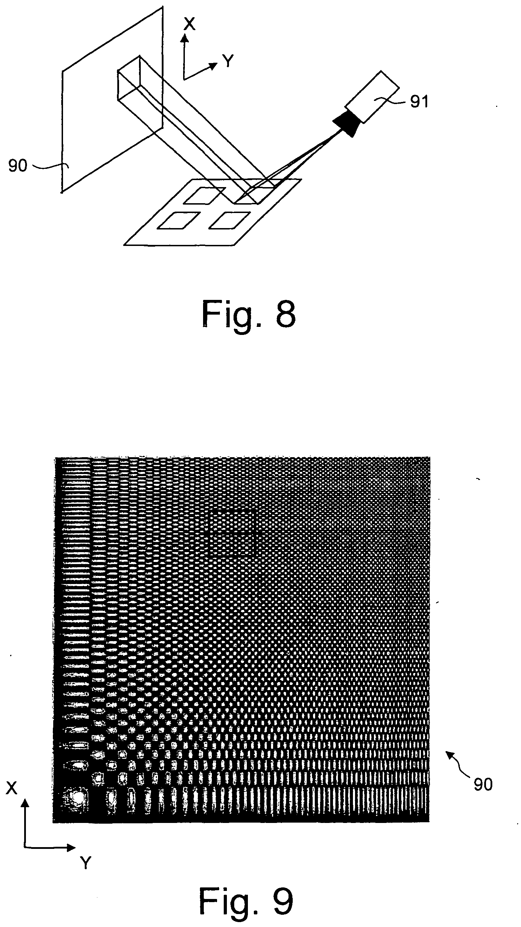

Figur 8 zeigt eine weitere Möglichkeit, die Ausrichtung der Spiegelelemente 28 des Multi-Mirror-Arrays 26 zu bestimmen. Dabei wird ein leuchtendes Muster an dem Multi-Mirror-Array 26 gespiegelt und in eine Kamera 91 abgebildet. Das leuchtende Muster kann z.B. durch Beleuchtung eines teilreflektierenden Schirmes 90, der das Muster trägt, oder durch Durchleuchten einer transparenten Folie (ähnlich wie ein Diapositiv) erzeugt werden.

Figur 9 zeigt beispielhaft ein für die Zwecke der Messung geeignetes Muster. Das Muster weist schachbrettartige Wechsel zwischen Hell und Dunkel auf, deren Frequenz entlang der beiden Schirmachsen x_Schirm und y_Schirm kontinuierlich zunimmt, so dass keine zwei Bereiche des Schirmes 90 ein identisches Muster aufweisen. Betrachtet man einen Ausschnitt des Kamerabildes, der einem Spiegelelement 28 entspricht, so ist, je nach Verkippung des Spiegelelements 28, ein anderer Bereich des Muster in diesem Ausschnitt sichtbar. Mit Hilfe einer Auswerteeinheit, die beispielsweise eine Autokorrelation zwischen dem Ausschnitt des Kamerabildes und dem bekannten Muster des Schirmes 90 durchführt, kann so die genaue Verkippung des Spiegelelements 28 erfasst werden. Da die Kamera so angeordnet sein kann, dass sie mehrere Spiegelelemente 28 erfasst und jedes Spiegelelement 28 individuell einen Bereich des Schirmmusters zeigt, kann mit dieser Einrichtung die Verkippung mehrere Spiegelelemente 28 gleichzeitig bestimmt werden.

Anstatt einem geordneten Muster, wie dem in Figur 9 gezeigten, kann auch ein zufälliges Muster gewählt werden, solange es eine möglichst schmale Autokorrelationsfunktion aufweist.

Eine andere Möglichkeit besteht darin, entlang der beiden Schirmachsen x_Schirm und y_Schirm unterschiedliche Farbverläufe vorzusehen und so eine Farbkodierung der unterschiedlichen Orte auf dem Schirm zu erreichen. Theoretisch würde dann eine farbempfindliche Kamera 91 oder ein sonstiger farbempfindlicher Sensor mit nur einem Pixel ausreichen, um über das oben erläuterte Verfahren den Verkippungswinkel der Spiegelelemente 28 zu bestimmen. Da bei kommerziell erhältlichen digitalen Farbkameras der Farb- oder RGB-Vektor bereits direkt vorliegt, wäre die Auswertung auch sehr einfach und wenig rechenintensiv.

### 6. Kalibrierung - erstes Ausführungsbeispiel

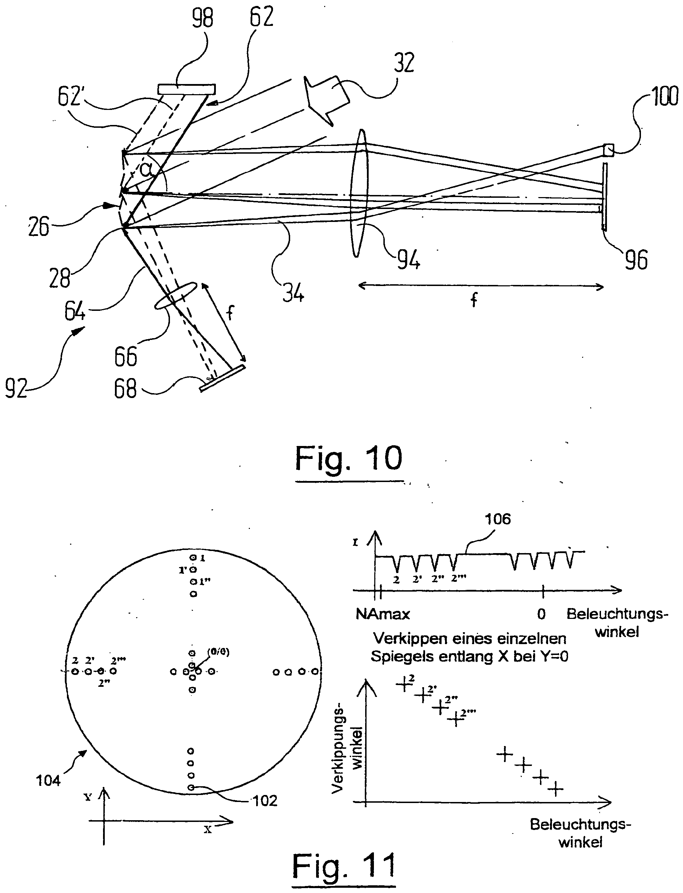

Figur 10 zeigt eine vereinfachte Darstellung einer Anordnung, die eine Kalibrierung der Messeinrichtung gemäß einem ersten Ausführungsbeispiel ermöglicht. Die Kalibrierung stellt eine Verknüpfung her zwischen den tatsächlichen Strahlablenkungen des reflektierten Projektionslichts 34, das die Pupillenebene des Beleuchtungssystems 12 mit der gewünschten Intensitätsverteilung ausleuchten soll, und den über die Messeinrichtung erfassten Signalen. Die hier geschilderte Kalibrierung ist aber auch dann verwendbar, wenn die Signale, welche die Ausrichtung der Spiegelelemente 28 beschreiben, nicht von der oben beschriebenen Messeinrichtung bereitgestellt werden, sondern von anderen Sensoren oder Messeinrichtungen. In Betracht kommen in diesem Zusammenhang z.B. beispielsweise an dem Multi-Mirror-Array 26 angeordnete elektromechanische oder kapazitive Sensoren, welche die Kippwinkel gewissermaßen von "innen" her erfassen.

Bei einem in Figur 10 stark vereinfacht dargestellten Pupillenformungsteil 92 eines Beleuchtungssystems 12 fällt das von einer Projektionslichtquelle, z.B. einem Excimer-Laser, erzeugte Projektionslicht 32 auf ein Multi-Mirror-Array 26 und wird nach der Spiegelung an diesem über eine Pupillenoptik 94 in die Pupillenebene 96 des Beleuchtungssystem 12 gerichtet. Da die Packungsdichte eines für einen solchen Zweck geeigneten Multi-Mirror-Arrays 26 üblicherweise 90%-95% nicht übersteigt und somit zwischen den einzelnen Spiegelelementen 28 nicht oder in unerwünschter Weise reflektierende Stege existieren, wird bei diesem Ausführungsbeispiel das einfallende Projektionslicht 32 mittels Mikrolinsen-Arrays in kleineren Projektionslichtbündeln auf die Spiegelelemente 28 fokussiert, wie dies an sich im Stand der Technik bekannt ist.

Über einen separaten Strahlengang wird ferner kollimierte Messlichtbündel 62 unter einem größeren Einfallswinkel α' auf das Multi-Mirror-Array 26 gerichtet. Im vorliegenden Ausführungsbeispiel umfasst die Messbeleuchtungseinrichtung eine Anordnung mehrerer Halbleiterlaser, die Licht aus ihrer flachen Halbleiterfläche emittieren. Mit einem solchen sogenannten VCSEL-Array 98 (*Vertical Cavity Surface Emitting Laser Array*) kann gezielt jedes einzelne Spiegelelement 28 des Multi-Mirror-Arrays 26 mit einem kollimierten Messlichtbündel 62 beleuchtet werden. Zur Veranschaulichung der Individuellen Schaltbarkeit ist in Figur 10 der Strahlengang zweier momentan ausgeschalteter Messlichtbündel 62' gestrichelt dargestellt. Nach der Reflexion an dem Multi-Mirror-Array 26 treffen die Messlichtbündel 62 als reflektierte Messlichtbündel 64 über eine Detektorsammellinse 66 auf einem Positionssensor 68 auf, der in der Brennebene der Detektorsammellinse 66 angeordnet ist. Aufgrund der Detektorsammellinse 66 bewirkt eine Winkeländerung der reflektierten Messlichtbündel 64 auf dem Positionssensor 68 eine Verschiebung der Brennpunkte, auf welche die reflektierten Messlichtbündel 64 fokussiert werden.

Zur Kalibrierung der Messeinrichtung weist die Anordnung ferner einen Projektionslichtdetektor 100 auf, der an einer präzise vorgegebenen Position in der Pupillenebene, aber in unmittelbarer Nachbarschaft neben der nutzbaren Pupillenöffnung, insbesondere in einem Abstand kleiner als ein Fünftel des Durchmessers der Pupillenöffnung, angeordnet ist. Soll nun die Messung der Verkippungswinkel eines einzelnen Spiegelelements 28 kalibriert werden, so wird nur das entsprechende Spiegelelement 28 so lange verkippt, bis das von diesem reflektierte Projektionslichtbündel 34 auf den Projektionslichtdetektor 100 in der Pupillenebene trifft. Wird zeitgleich ein Messlichtbündel 62 auf das zu kalibrierende Spiegelelement 28 gerichtet, so kann die dabei festgestellte Position des Brennpunktes auf dem Positionssensor 68 als Kalibrierwert in einer Auswerteeinheit hinterlegt werden.

Um Nichtlinearitäten zu erfassen, wie sie z.B. durch die Pupillenoptik 94 oder durch gekrümmte Spiegeloberflächen 30 entstehen können, ist es vorteilhaft, um die Pupillenöffnung herum mehrere, insbesondere vier, Projektionslichtdetektoren 100 anzuordnen. Die Projektionslichtdetektoren 100 können auch als 4-Quadrantendetektoren ausgebildet sein.

Sind die Verkippungswinkel eines jeden Spiegelelements 28 in der vorstehend beschriebenen Weise kalibriert, kann die Messeinrichtung dazu verwendet werden, während des Betriebs des Beleuchtungssystems 12 die Verkippung der Spiegelelemente 28 und damit die Ausleuchtung der Pupillenebene zu überwachen, um die Spiegelelemente 28 gegebenenfalls nachzujustieren. Im allgemeinen wird eine solche Nachjustierung sinnvoll sein, da hochfrequente Störungen im Bereich von 100 Hz bis 1000 Hz, wie sie z.B. durch Schwingungen der Spiegelelemente 28 aufgrund von Luftströmungen oder akustischen Wellen auftreten können, zu untolerierbaren Fehlern in der Ausleuchtung der Pupillenebene führen würden.

Ferner können über das beschriebene Kalibrierverfahren auch Fehlbeleuchtungen erfasst werden, die sich aus langsamen Driftbewegungen zwischen den Spiegelelementen 28 des Multi-Mirror-Arrays 26 und dem Mikrolinsen-Array ergeben, welches das Projektionslicht 32 auf die Spiegelelemente 28 fokussiert. Diese werden von der Messeinrichtung zunächst nicht erfasst, da dieses anderen Driftbewegungen unterliegt. Da ein einzelnes Spiegelelement 28 auch während des Betriebs des Beleuchtungssystem 12 auf den Projektionslichtdetektor 100 ausgerichtet werden kann, ohne dass dies die Ausleuchtung der Pupillenebene wesentlich beeinflusst, kann die Kalibrierung in bestimmten Zeitabständen nach und nach für jedes Spiegelelement 28 während des Betriebs wiederholt werden. Dadurch werden die langsamen Driftbewegungen erfasst und korrigiert. Je nach dem, wie groß der Anteil des aus dem normalen Strahlengang des Beleuchtungssystems 12 auskoppelten Projektionslichts sein kann, können die Zeitabstände variiert werden oder einzelne, wenige oder alle Spiegelelemente 28 gleichzeitig auf diese Weise kalibriert werden.

### 7. Kalibrierung - zweites Ausführungsbeispiel

Figur 11 illustriert in einer Übersichtsdarstellung ein weiteres Verfahren zur Kalibrierung der oben näher beschriebenen Messeinrichtung. Auch das Kalibrierungsverfahren gemäß diesem Ausführungsbeispiel ist unabhängig von dieser Messeinrichtung verwendbar. Somit kommt auch ein Einsatz in Betracht, wenn die Signale, welche Informationen über die Ausrichtung der Spiegelelemente 28 enthalten, nicht von der oben beschriebenen Messeinrichtung, sondern von anderen Sensoren oder Messeinrichtungen bereitgestellt werden.

Insbesondere kann das Kalibrierverfahren dieses Ausführungsbeispiels in vorteilhafter Weise verwendet werden, um die Stellgrößen zur Ansteuerung der Spiegelelemente 28 direkt zu kalibrieren, falls ein sogenannter Feed-Forward-Betrieb des Multi-Mirror-Arrays 26 gewählt wird, bei dem keine separaten Sensor- oder Messeinrichtungen zur Rückkopplung vorgesehen sind. Wie aus den nachfolgenden Erläuterungen klar werden wird, beruht dies auf der Tatsache, dass das vorgestellte Kalibrierverfahren zur Nachkalibrierung eventueller, schleichender Prozesse, wie Drift, elektrischer Aufladungen, u. a. mit geringem Aufwand schnell wiederholbar ist und sogar für einzelne Spiegelelemente während eines Belichtungsprozess der Belichtungsanlage 10 durchführbar ist.

Gemäß diesem Ausführungsbeispiel werden an bestimmten Stellen der Pupillenfläche Bereiche 102 mit einer verminderten Transmission von 50% erzeugt. Zu diesem Zweck kann beispielsweise eine transparente Kalibrierplatte 104 in oder in der Nähe der Pupillenfläche angeordnet sein. Die Bereiche 102 mit verminderter Transmission haben jeweils die Größe des von einem reflektierten Projektionslichtbündel 34 in der Pupillenfläche erzeugten Lichtflecks. Sie bilden dabei eine Art Kalibriermaß, das in Bezug auf die optische Achse des Beleuchtungssystems 12 entweder fest oder auswechselbar an einer genau festgelegten Position und mit winkelmäßig präzise ausgerichtet angeordnet ist. Durch geeignet Methoden können die Bereiche 104 mit verminderter Transmission auch an oder in bereits vorhandenen Elementen, etwa in der Pupillenoptik 94, angeordnet sein.

Zur Kalibrierung eines Spiegelelements 28 wird in eine Feldebene, z.B. der Objektebene oder der Bildebene des Projektionsobjektivs 20, ein Intensitätssensor eingebracht. Während ein einzelnes Spiegelelement 28 durch das ihm zugeordnete reflektierte Projektionslichtbündel 34 entlang vorbestimmter Pfade, beispielweise entlang einer Koordinatenachse, verschiedene Orte der Pupillenfläche ausleuchtet, zeichnet der Intensitätssensor den Intensitätsverlauf 106 (siehe Graph rechts oben in Figur 11) auf. Ein solcher Intensitätsverlauf 106 ist in Figur 11 beispielhaft für eine Bewegung eines Spiegelelements 28 dargestellt, bei welcher der Lichtfleck entlang der X-Achse mittig, d.h. über die optische Achse hinweg, über die Pupillenfläche wandert. Fällt das von dem Spiegelelement 28 kommende reflektierte Projektionslichtbündel 34 auf einen Bereich 104 mit verminderter Transmission, so wird dies als ein Abfall der Intensität von dem Intensitätssensor registriert.

Mit Hilfe geeigneter Anordnungen der Bereiche 102 mit verminderter Transmission und einer entsprechenden Auswerteeinheit, welche die Minima des Intensitätsverlauf 106 erfasst und in Kenntnis der Anordnungen der Bereiche 104 bestimmten Positionen innerhalb der Pupillenfläche zuordnet, können auf diese Weise die Messsignale der Messeinrichtung, die zeitgleich die Ausrichtung der Spiegelelemente misst, kalibriert werden. Dadurch wird der von der Messeinrichtung bestimmte Verkippungswinkel der Spiegelelemente 28 mit der absoluten Winkellage des Beleuchtungswinkels des Projektionslichts 32 in Verbindung gebracht, wie dies in dem Graphen rechts unten in Figur 10 angedeutet ist.

Bei einer vorteilhaften Weiterbildung wird anstelle eines normalen Intensitätssensors in einer Feldebene ein winkelauflösender Intensitätssensor verwendet. Damit kann man nicht nur feststellen, ob überhaupt Licht auf einen Punkt in der Feldebene auftrifft, sondern auch, aus welchen Richtungen Licht auf diesen Punkt fällt. Da den Orten in der Pupillenfläche unterschiedliche Richtungen in der Feldebene zugeordnet sind, kann man mit einem solchen winkelauflösenden Intensitätssensor sogar mehrere Spiegelelemente 28 gleichzeitig kalibrieren. Die jeweils ausgeleuchteten Bereiche 102 mit verminderter Transmission sollten dann möglichst so weit auseinander liegen, dass der Intensitätssensor die in der Feldebene zugeordneten Richtungen noch ausreichend genau auflösen kann.

Um zu verhindern, dass im Projektionsbetrieb der Projektionsbelichtungsanlage 10 auf der Pupillenfläche in den Bereichen 102 mit verminderter Transmission lokale Intensitätssenken auftreten, werden auf auszuleuchtende Bereiche 102 jeweils doppelt so viele reflektierte Projektionslichtbündel 34 gerichtet, wie ansonsten vorgesehen wären. Da die Transmission dieser Bereiche 102 wie oben angegeben 50% beträgt, erzeugt die doppelte Zahl von Projektionslichtbündeln 34 somit die gewünschte Intensität. Auf diese Weise kann in der Pupillenfläche trotz der fest eingesetzten Kalibrierplatte 104 eine homogene Intensitätsverteilung erzeugt werden.

Alternativ hierzu kann die Kalibrierplatte 104 während des normalen Projektionsbetriebs auch aus dem Strahlengang entfernt werden.

### 8. Regelung - erfindungsgemäßes Ausführungsbeispiel

Bisher wurden Vorrichtungen und Verfahren beschrieben, die geeignet sind, den Verkippungswinkel der einzelnen Spiegelelemente 28 eines Multi-Mirror-Arrays 26 zu bestimmen. Stehen nun Informationen über die Verkippungswinkel zur Verfügung, so muss über ein Regelsystem dafür gesorgt werden, dass ein bestimmter Sollwert für den Verkippungswinkel möglichst genau eingehalten wird.

Hierzu kann ein Regelkreis verwendet werden, der je nach erfasstem Sensorsignal der Messeinrichtung derart auf die Stellgrößen s zur Steuerung der Verkippungswinkel der Spiegelelemente 28 einwirkt, dass der Sollwert des Verkippungswinkels möglichst genau eingehalten wird. Üblicherweise wird zu solch einem Zweck ein sogenannter PID-Regler eingesetzt, der als Eingangssignal die Regeldifferenz e, d.h. die Abweichung zwischen dem Sollwert und dem Istwert des Spiegelwinkels, erhält. Je nach Einstellung des Proportional- (P), Intergral- (I) und Differentialanteils (D) des PID-Reglers wird dann die Stellgröße s entsprechend gesetzt, was sich seinerseits wieder auf den Istwert des Spiegelwinkels auswirkt. Eine derartig geschlossene Regelschleife wird mit der sogenannten Regelfrequenz f betrieben.

Hierbei ergeben sich jedoch in Bezug auf die Regelung der Spiegelelemente 28 eines Multi-Mirror-Arrays 26 folgende Problemstellungen. Zum einen ist ein Differenzieren des Sensorsignals oftmals schwierig, da die Sensorwerte der Messeinrichtung stark unsicherheitsbehaftet sind. Das Differenzieren über diskrete Filter in dem für den Differentialanteil (D) zuständigen Regelglied kann deshalb zu einer derart starken Rauschverstärkung führen, dass das sich ergebende Regelsignal unbrauchbar ist. Zum anderen kann die Regeldifferenz e nur mit der Abtastfrequenz errechnet werden, mit der auch die Messwerte für die Verkippungswinkel der Spiegelelemente 28 vorliegen. Aufgrund der hohen Anzahl von Spiegelelementen 28, z.B. einigen Tausend oder sogar mehreren Zehntauschen Spiegelelementen 28, ist die maximale Abtastfrequenz für ein einzelnes Spiegelelement 28 stark begrenzt. Damit kann aber auch der Regelkreis nur mit einer Regelfrequenz f betrieben werden, die dieser geringen Abtastfrequenz entspricht, was zu größeren Abweichungen vom Sollwert führen kann.

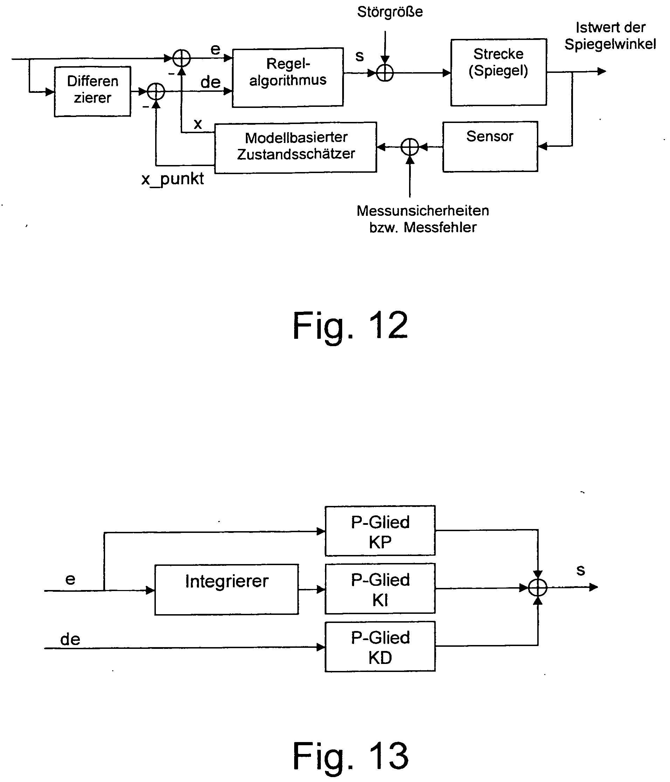

Figur 12 zeigt das Regelschema eines erfindungsgemäßen Regelkreises, der einen modellbasierten Zustandsschätzer verwendet und deswegen die vorstehend genannten Nachteile nicht aufweist. Der modellbasierte Zustandsschätzer schätzt basierend auf einem Modell und anhand der unsicherheitsbehafteten Sensorsignale den aktuellen Verkippungswinkel der Spiegelelemente 28. Hierzu berechnet der modellbasierte Zustandsschätzer mittels eines internen Modells aus den unsicherheitsbehafteten Sensorsignalen den geschätzten Zustandvektor, d.h. den geschätzten Verkippungswinkel x und die zeitliche Ableitung x_punkt des Verkippungswinkels.

Dieser geschätzte Zustandsvektor wird dann mit dem Sollzustand des Systems, d.h. dem eigentlichen Sollwert des Verkippungswinkels und dessen zeitlicher Ableitung, verglichen. Obwohl auch hier die zeitliche Ableitung des Verkippungswinkels durch Differenzieren aus dem Sollwert des Spiegelwinkels bestimmt wird, stellt diese Differenzierung kein Problem dar, da der Sollwert des Verkippungswinkels nicht unsicherheitsbehaftet ist. Neben der Regeldifferenz e erhält man aus diesem Vergleich die zeitliche Ableitung de der Regeldifferenz, die zusammen den Regeldifferenzvektor (e, de) bilden.

Dieser Regeldifferenzvektor (e, de) wird nun an einen Regelalgorithmus übergeben, der die Stellgröße s berechnet und an die Steuerung des Spiegelelements 28 übergibt. Das Regelschema dieses Regelalgorithmus ist im Detail in Figur 13 gezeigt. Wie aus der Figur 13 ersichtlich ist, weist der Regelalgorithmus drei Proportionalglieder auf, mit denen sich der Einfluss der verschiedenen Regelanteile bestimmen lässt. Ein erstes Proportionalglied KP entspricht dem Proportionalanteil (P) eines PID-Reglers, in dem die Regeldifferenz e nur mit einer Konstanten multipliziert wird. Ein zweites Proportionalglied KI multipliziert das Ausgangssignal eines Integrierers, der die Regeldifferenz e integriert, mit einer Konstanten und entspricht daher dem Integralanteil (I) eines PID-Reglers. Ein drittes Proportionalglied KD entspricht dem Differentialanteil (D) eines PID-Reglers, in dem die zeitliche Ableitung de der Regeldifferenz e, die der Regelalgorithmus wie oben erläutert übergeben bekommt, mit einer Konstanten multipliziert wird. Alle drei Regleranteile werden addiert und als Stellgröße s ausgegeben.

Ein derartiger Regelkreis kann aufgrund des modellbasierten Zustandsschätzers auch in digitaler Form mit stärker unsicherheitsbehafteten Messsignalen eingesetzt werden, als dies bei einem üblichen PID-Regler der Fall ist.

Als Ausgangspunkt bei der Realisierung des modellbasierten Zustandschätzers empfiehlt es sich, aus der Literatur bekannte Zustandsschätzer zu verwenden, die besonders geeignet sind, stochastische Unsicherheiten der Messsignale bei der Schätzung zu berücksichtigen, und diese Zustandsschätzer entsprechend den Anforderungen des speziellen Anwendungsfalls anzupassen. Beispiele hierfür sind der Kalman-Filter, der erweiterte Kalman-Filter (EKF), der unscented Kalman-Filter (UKF) oder der Partikelfilter.

Da solche modellbasierten Zustandsschätzer den geschätzten Zustandsvektor (x, x_punkt) auch mit einer Rate ausgeben können, die höher als die Abtastfrequenz des Messsignals liegen, kann die Regelung trotz der großen Anzahl an Spiegelelementen 28 und der damit verbundenen kleinen Abtastfrequenzen jedes einzelnen Spiegelelements 28 mit einer hohen Regelfrequenz f erfolgen. Dadurch lässt sich eine ausreichende Genauigkeit der Verkippungswinkel der Spiegelelemente 28 erzielen.

Bei einem Kalman-Filter wird zwischen einer kinematischen Modellvariante, die auf einer Taylorentwicklung des aktuellen Verkippungswinkels basiert, und einer dynamischen Modellvariante unterschieden, die das Verhalten des Systems gerade in den Zeiträumen, in denen keine Messwerte vorliegen, präziser nachgebildet.

Alle Regelelemente können ferner zur Regelung mehrerer Spiegelelemente 28 mehrfach oder gemeinschaftlich vorhanden sein. Daher kann man alle Regelgrößen wie beispielsweise die Stellgröße s als Vektor, dessen Zahl der Komponenten gleich der Zahl der Spiegelelemente 28 ist.

Selbstverständlich ist für solch eine Anwendung eine Implementierung des Regelkreises als Software oder auf einem FPGA-Chip besonders geeignet, da insbesondere der modellbasierte Zustandsschätzer auf diese Weise flexibel gestaltet werden kann.

### 9. Regelung - alternatives Ausführungsbeispiel

Eine wichtiger Aspekt bei einem Beleuchtungssystem 12, das ein Multi-Mirror-Array 26 zur Ausleuchtung einer Pupillenfläche aufweist, ist die Geschwindigkeit und die Genauigkeit, mit der die einzelnen Spiegelelemente 28 eingestellt werden können. Die Eckdaten für die Messeinrichtung, welche die Verkippung der Spiegelelemente 28 erfasst, sind dabei durch die optischen und mechanischen Anforderungen an das Designs des Pupillenformungsteil 92 des Beleuchtungssystems 12 und des Beleuchtungssystems 12 insgesamt gegeben.

Bei einem Ausführungsbeispiel weist das Multi-Mirror-Array 26 insgesamt 64 x 64 = 4096 Spiegelelementen 28 auf, die in jeweils zwei Achsen separat angesteuert und deren Verkippungswinkel einzeln gemessen werden müssen. Mit den bisher im Stand der Technik bekannten Lösungen ist eine derartig hohe Anzahl an Spiegelelemente 28 nicht mit den geforderten Genauigkeiten und innerhalb der kurzen Zeiten einstellbar, die sich aus den Anforderungen an moderne Projektionsbelichtungsanlagen 10 ergeben. Jedes Spiegelelement 28 soll nämlich einen Verkippungswinkel von mindestens ±2°, nach Möglichkeit ±3°, in beiden Achsen um eine gegebene Neutrallage anfahren können, wobei das Steuersystem diesen Winkelbereich mit einer systematischen Genauigkeit von ca. 11 Mikroradian und einer statistischen Unsicherheit von ca. 140 Mikroradian beherrschen muss.

Daher ist es notwendig, die Spiegelpositionen zu messen und mittels eines Regelkreises Korrekturen anzubringen. Für die Messung des gesamten Satzes von 4096 Spiegelelementen 28 steht dabei eine Zeit von ca. 1 ms zur Verfügung, d.h. die Kippwinkel jedes einzelnen Spiegelelements 28 müssen in ca. 250 ns mit der erforderlichen Genauigkeit bestimmt werden können. Die Verkippungswinkel der Spiegelelemente sollen ferner mit Hilfe von je einem Messlichtbündel 62 gemessen werden (siehe Ausführungsbeispiel der Figur 10), wobei die Ausbreitungsrichtung des reflektierten Messlichtbündels 64 nach der Reflexion an der Spiegeloberfläche 30 Aufschluss über die Kippwinkel gibt. Die Aufgabe ist somit, die Kippwinkel der reflektierten Messlichtbündel 64 hinreichend schnell zu bestimmen.

Hierfür werden, wie oben erläutert, durch den Einsatz einer Fourier-Optik, wie beispielsweise der Detektorsammellinse 66, Winkel in Positionen umgewandelt und diese auf einem Positionssensor 68 erfasst. Durch Beschränkungen im Bauraum ist es aber nur schwer möglich, 4096 parallele Detektoreinrichtungen, wie dies für das Ausführungsbeispiel der Figur 5 gezeigt ist, einzusetzen. Ohne größeren Aufwand kann also, wie dies auch bei dem in Figur 10 gezeigten Ausführungsbeispiel der Fall ist, jeweils nur ein Exemplar des Positionssensor 68 und der Fourier-Optik eingesetzt werden. Mit erheblichem Aufwand sind ca. vier Detektoreinrichtungen installierbar, aber derzeit wohl kaum 4096 Detektoreinrichtungen. Ziel ist es daher, die Anforderungen an die Mess- und Steuerungseinrichtung mit nur einem Positionssensor 68 und einer Fourier-Optik zu erfüllen.

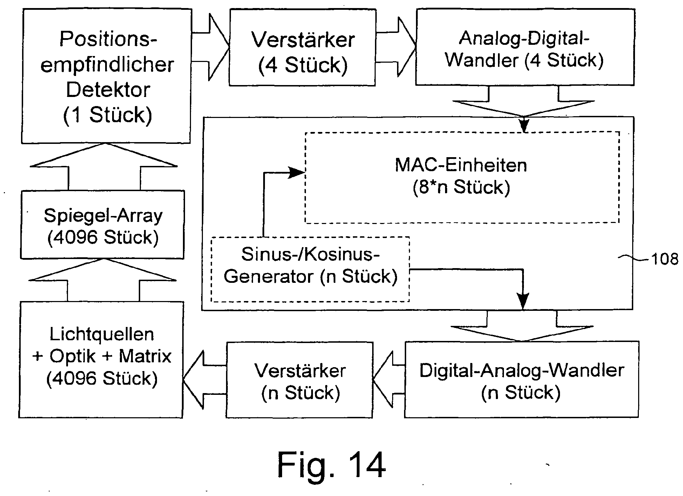

Hierzu zeigt Figur 14 den schematischen Aufbau einer Vorrichtung, mit der ein Multiplex-Verfahren möglich ist, das die parallele und unabhängige Messung von mehreren Spiegelelementen 28 mit nur einem Positionssensor 68 ermöglicht.

Wie beim Ausführungsbeispiel aus Figur 10 erwähnt, können als Lichtquellen für die Messbeleuchtung Anordnungen von Laserdioden, sogenannte VCSEL-Arrays 98, verwendet werden. Solche VCSEL-Arrays 98 mit einem quadratischen oder hexagonalen Gitter von 64 x 64 Gitterpunkten sind bereits kommerziell erhältlich. Mittels einer Matrixansteuerung, bei der die Anoden und Kathoden jeweils in Zeilen bzw. Spalten miteinander verbunden sind, ist die gleichzeitige, unabhängige Steuerung von bis zu 64 Laserdioden, beispielsweise innerhalb einer Zeile, möglich. Das Licht der Laserdioden wird dann über die Kollimator-Sammellinsen 60 eines fest am VCSEL-Array 98 montierten Mikrolinsen-Arrays auf das Multi-Mirror-Array 26 fokussiert.

Als Positionssensor 68 kommen verschiedene kommerzielle Lösungen in Frage. Mit einer Bandbreite von ca. 4 MHz und einem Rauschen, das die geforderte Messgenauigkeit gerade noch zulässt, sind bereits Positionssensoren 68, die kurz auch PSDs genannt werden, kommerziell erhältlich (z.B. der Typ 2L4 von SiTek). Da die Messzeit je Spiegelelement 28 jedoch nur ca. 250 ns betragen darf, ist dieser Positionssensor 68 im Hinblick auf die Geschwindigkeit der Messung schon an der Grenze seiner Leistungsfähigkeit. Daher wird bereits nach Alternativen für den Positionssensor 68 gesucht, die die geforderte Ortauflösung leisten und noch kürzere Messzeiten erlauben. Deshalb bezieht sich dieser Ansatz auf alle Detektorarten, wobei die Daten des 2L4 PSDs von SiTek als Ausgangspunkt verwendet werden können.

Aus den publizierten Daten von PSD, Verstärkerschaltungen und Analog-Digital-Wandlern kann man auf den theoretisch erreichbaren statistischen Ortsfehler schließen. Da dieser etwas geringer ist als die Anforderungen, ist es also theoretisch möglich, die Spiegelelemente 28 durch zeitliches Multiplexen auszumessen,. Die Laserdioden des VCSEL-Arrays 98 werden dabei der Reihe nach angeschaltet, so dass immer nur das von einem Spiegelelement 28 reflektierte Messlichtbündel 64 auf den Positionssensor 68 trifft. Durch die endliche Bandbreite der Laserdioden und des Positionssensor 68 wird der für die Messung brauchbare Zeitraum jedoch auf unter 100 ns verkürzt. Diese Methode soll im folgenden als "sequenziell" bezeichnet werden, weil die Lichtquellen streng der Reihe nach angeschaltet werden und nur jeweils eine gleichzeitig leuchtet.

Um den beschränkenden Faktoren, wie beispielsweise der Signalanstiegszeit des Positionssensors 68, den DC-Offsets und deren Drift sowie dem 1/f-Rauschen der Verstärker entgegenzuwirken, werden die Laserdioden nicht nacheinander an- und ausgeschaltet, sondern in Gruppen von z.B. vier oder acht Laserdioden gleichzeitig betrieben. Die Intensitäten der einzelnen Laserdioden einer Gruppe werden allerdings sinusförmig mit verschiedenen Frequenzen moduliert. Durch eine phasenempfindliche Detektion der Elektrodenströme des Positionssensors 68, d.h. dessen Ausgangssignale, werden die Anteile der verschiedenen reflektierten Messlichtbündel 64 an den verschiedenen Orten des Positionssensor 68 entsprechend ihrer modulierten Frequenzen separiert. Einfach gesagt ist das erfindungsgemäße Verfahren analog zu einer Messung mit mehreren parallel betrieben Lock-In-Verstärkern.

Dadurch wird die Wirkung der Signalanstiegszeit des Positionssensors 68 als harte Grenze der Leistungsfähigkeit der Messeinrichtung vermindert. Im Bereich der Bandbreite und mit reduzierter Amplitude darüber hinaus sind somit Messungen der Verkippungswinkel mehrer Spiegelelemente 28 möglich. Ferner wird die Wirkung aller DC-Effekte, also Offsets, Drifts sowie 1/f-Rauschen, ausgeblendet. So wird beispielsweise durch die AC-Kopplung der Verstärker ermöglicht, auf die für den PSD-Bias des Positionssensors 68 notwendigen Differenzverstärker zu verzichten, womit deren Rauschen entfällt. Zudem wird die Wirkung der "Tot-zeit", in der das System einschwingt und keine Messungen möglich sind, erheblich reduziert.

Als Nebeneffekt der AC-Kopplung wird auch die Qualität der Digitalisierung der Sensorsignale des Positionssensors 68 verbessert, da die neueste Generation schneller Analog-Digital-Wandler, die unabhängig von der verwendeten Messmethode notwendig sind, ihre höchste Auflösung nur bei AC-Kopplung erzielen.

In Abweichungen von dem an sich bekannten Lock-In-Prinzip wird das System nicht mit einer, sondern mit mehreren Frequenzen gleichzeitig moduliert. In dieser Eigenart gleicht das System entfernt einem Fourier-Interferometer.

Eine besondere Wahl der Frequenzen und der Datenaufnahmezeiten erlaubt es, streng periodische Randbedingungen zu benutzen. Somit ist eine fehlerfreie Fourier-Analyse auch von sehr kurzen Datenfolgen möglich, und die Verwendung einer Glättung oder eines multiplikativen "Fensters" wie bei Lock-In-Verstärkern nicht notwendig.

Den leicht ersichtlichen Vorzügen des beschriebenen Verfahrens stehen zwar auch einige Nachteile gegenüber, jedoch lassen diese sich leicht überwinden:
Die maximale Lichtintensität, die ein Positionssensor 68 verarbeiten kann, ist begrenzt. Daher sollte die Leuchtstärke jeder einzelnen Lichtquelle reduziert werden, wenn mehrere Lichtquellen gleichzeitig leuchten, wodurch das Verhältnis von Signalamplitude zum Rauschen sinkt. Durch die längere zur Verfügung stehende Messzeit wird dieser Amplitudenverlust jedoch kompensiert, womit durch die Begrenzung der maximalen Lichtintensität allein kein zusätzlicher Messfehler verbunden ist.

Aufgrund der Wahl der Frequenzen (siehe unten) wird eine Bandbreite benötigt, die größer als 4MHz ist. Je mehr Lichtquellen gleichzeitig moduliert werden, umso größer ist die benötigte Bandbreite. Durch die endliche Bandbreite des Positionssensors 68 wird die Signalamplitude bei höheren Frequenzen geringer und dadurch der statistische Fehler größer.

Zur erfolgreichen Umsetzung der Technik ist die richtige Wahl der Messfrequenzen entscheidend. Um das Fenster-Problem bei der Fourier-Analyse zu umgehen, werden die Frequenzen so gewählt, dass im Messintervall jeweils eine ganze Zahl an Perioden jeder Frequenz vermessen wird. Damit sind die Grenzen des Messintervalls für alle Frequenzen periodische Randbedingungen. Ein Fenster ist somit nicht erforderlich, und die Messsignale sind exakt orthogonal, was ein Kanalübersprechen bei der Fourier-Analyse verhindert.

Das VCSEL-Array 98 und seine Elektronik zeigen keinen linearen Zusammenhang zwischen Ansteuersignal und Lichtleistung. Somit enthält das Lichtfeld zusätzlich zu den Messfrequenzen auch ihre Harmonischen. Fallen solche Harmonische einer Laserdiode mit der Messfrequenz einer anderen Laserdiode (d.h. eines anderen Spiegelelements 28) zusammen, so wird das dieser anderen Laserdiode zugeordnete Messergebnis verfälscht. Keine Messfrequenz sollte deswegen ein Vielfaches einer anderen Messfrequenz sein. Um dies zu garantieren, werden die Frequenzen wie Primzahlen innerhalb der Bandbreite verteilt.

Im konkreten Beispiel gilt es, einen Messtakt pro Spiegel von 250 ns zu erreichen. Bei vier gleichzeitig aktiven Lichtquellen werden vier Frequenzen benötigt, um vier Spiegelelemente 28 gleichzeitig zu vermessen. Eine solche Messung dauert daher (unter Vernachlässigung der Einschwingzeit, die in der Größenordnung von 200 ns liegt) 1 ps. Die periodischen Randbedingungen gelten also für Frequenzen, die Vielfache von 1 MHz sind. Die ersten vier primzahligen Vielfachen von 1 MHz sind also Frequenzen 2 MHz, 3 MHz, 5 MHz und 7 MHz. Bei acht simultanen Messungen ist das Intervall 2 ps lang und die Messfrequenzen betragen 1, 1.5, 2.5, 3.5, 5.5, 6.5, 8.5 und 9.5MHz. Die optimale Wahl der Anzahl der Frequenzen hängt von der Bandbreite des Positionssensors 68 ab. Simulationen haben ergeben, dass das Optimum bei dem Silek 2L4 und den geforderten Eckdaten zwischen vier und acht Frequenzen liegt, der genaue Wert kann auch experimentell bestimmt werden. Da die Dichte der Primzahlen mit steigendem Wert abnimmt, nimmt mit steigender Anzahl der Messfrequenzen auch die Bandbreite zu, wodurch die verwertbare Signalamplitude des Positionssensors 68 sinkt, was wiederum die Genauigkeit beeinträchtigt.

Durch die begrenzte Gesamtintensität, die am Positionssensors 68 maximal detektiert werden kann, muss auch die Lichtleistung der Lichtquellen so gewählt werden, dass die Sättigungsgrenze des Positionssensors 68 nicht überschritten wird. Dazu ist es sinnvoll, die Lichtquellen so anzusteuern, dass die maximale Gesamtintensität möglichst gering ist, damit die Durchschnittsleistung jeder einzelnen Lichtquelle möglichst hoch eingestellt werden kann. Da die Frequenzen durch die Primzahlverteilung festgelegt sind und jede Lichtquelle die gleiche Amplitude hat, kann die maximale Gesamtlichtleistung durch Einstellung der relativen Phasen minimiert werden. Eine nichtlineare numerische Minimierung hat ergeben, dass eine deutliche Reduktion der Maximalintensität allein durch geeignete Wahl der Phasen erreicht werden kann. Ausgedrückt in Vielfachen der Einzelmaximalintensität beträgt das Maximum z.B. bei 4 Lichtquellen 2.93, bei 6 Quellen 4.33, bei 8 Quellen 5.57.

Ein bedeutender Vorteil der vorgestellten Methode im Vergleich zur eingangs beschriebenen sequenziellen Abtastung der Spiegelelemente (ohne Modulation) ist, dass die Geschwindigkeit des Positionssensors 68 kein fundamentales Limit für die Messgenauigkeit darstellt. Es sind im Prinzip beliebig schnelle Messungen möglich, jedoch leidet durch die sinkende Signalamplitude die Messgenauigkeit. Dadurch ist es jedoch denkbar (und durch entsprechende Auslegung der Auswertungs-Software in der Recheneinheit leicht zu realisieren), dass auf Befehl zwischen verschiedenen Geschwindigkeiten und Genauigkeiten umgeschaltet wird. Somit kann für die aktive Dampfung der Spiegel z.B. eine Abtastzeit von 0.2 ms für alle Spiegel eingestellt werden, bei entsprechend großem Messfehler, und für den eigentlichen Einstellvorgang wieder auf 1 ms bei voller Genauigkeit zurückgeschaltet werden. Bei rein sequenzieller Messung wäre eine Messfrequenz von 0.2 ms mit der SiTek 2L4 nicht mehr zu erreichen. Dadurch ist diese Methode unter gegebenen Bedingungen (d.h. wenn mit der 2L4 von SiTek Abtastzeiten von 0.2 ms erreicht werden sollen, um aktiv zu dämpfen) nicht nur eine vorteilhafte, sondern möglicherweise sogar die einzig mögliche Lösung.

Zur Implementierung der Messmethode werden folgende Komponenten benötigt:
- Eine Messbeleuchtungseinrichtung mit einer Mehrzahl von Lichtquellen, die mit einer geeigneten Anzahl von Treiber-Verstärkern versehen ist, so dass Gruppen von 4, 6, 8, etc. Lichtquellen gleichzeitig betrieben werden können.
- Signalgeneratoren, die frequenz- und phasenkorreliert Sinussignale erzeugen können, wobei deren Anzahl gleich der der gleichzeitig angesteuerten Lichtquellen ist. Hierfür sind Generatoren nach dem DDS-Prinzip (Direct Digital Synthesis) gut geeignet.
- Vier Analog-Digital-Wandler, die die vorverstärkten Signale des Positionssensors 68 digitalisieren. Da die Technik auf Synchrondetektion beruht, ist die Taktquelle dieser Wandler von der gleichen Referenz abzuleiten wie der Takt der Signalgeneratoren.
- Eine Recheneinheit, die die Sensorsignale der Analog-Digital-Wandler auswerten kann. Durch die Art der Aufgabe ist es sinnvoll, an dieser Stelle eine programmierbare Logikeinheit zu verwenden, z.B. ein FPGA (Field-Programmable Gate Array). Die Recheneinheit (FPGA) hat demnach folgende Hauptaufgaben:
   ∘ Sammlung der Messdaten der vier ND-Wandler.
   ∘ Numerische Erzeugung von Sinus- und Cosinus-Signalen der gleichen Frequenzen wie die der Lichtquellen.
   ∘ Multiplikation der Sinus- und Cosinus-Signale mit dem A/D-Wandler-Daten. Dies er gibt pro verwendeter Frequenz acht Produkte.
   ∘ Aufsummierung der Produkte über das Messintervall. Diese Summen ergeben nicht normierte 0° und 90°-Komponenten, aus denen durch quadratische Addition die Amplitude des jeweiligen Eingangssignals bestimmt werden kann.

Aus den Amplituden wird durch einfache Addition, Subtraktion und Division die 2D- Winkelposition des jeweiligen Spiegels bestimmt. Für diese Operationen steht verhältnismäßig viel Zeit zur Verfügung, da sie nur zweimal pro Spiegel durchgeführt werden muss.

Durch Ausnutzung der Recheneinheiten, die in modernen FPGAs verfügbar sind, lässt sich diese Aufgabe in einem einzigen FPGA mit moderatem Aufwand bewerkstelligen.

Das Blockdiagramm der elektronischen Einrichtung inklusive der Hauptfunktionen des FPGA ist in Figur 14 zu sehen.

In der Recheneinheit 108 sind nur die rechenintensiven Operationen eingezeichnet. "MAC-Einheiten" sind Multipli-zierer-Addierereinheiten, die in 8 * n-facher Ausführung vorliegen, wobei n die Anzahl von Lichtquellen ist, die gleichzeitig mit verschiedenen Frequenzen moduliert werden. Bis auf die Recheneinheit 108, die als "Firmware" eines FPGA implementiert wird und nicht direkt in Hardware manifestiert ist, ist die Anordnung sehr ähnlich zu der einer herkömmlichen "sequenziellen" Messmethode und lässt sich dadurch kostengünstig aufbauen. In diesem Diagramm wurde bereits die Funktion der DDS-Einheiten weit-gehend in das FPGA integriert (D/A-Wandler rechts unten), diese ließe sich aber auch mit kommerziellen DDS-Bauteilen implementieren.

### 10. Schlussbemerkungen

Die vorstehend im Zusammenhang mit der Ausleuchtung einer Pupillenebene erwähnten Maßnahmen und Vorrichtungen können ohne weiteres in vorteilhafter Weise auch bei aktiven Masken eingesetzt werden, bei denen ebenfalls Anordnungen von Mikrospiegeln als schaltbare Elemente vorgesehen sind.

Ebenso können die Multi-Mirror-Arrays durch andere reflektive oder transmissive Elemente ersetzt werden, die es ermöglichen, einfallendes Licht in verschiedenen Teilbereichen des Elements durch Anlegen eines Steuersignals in unterschiedliche Richtungen abzulenken. Solche alternativen Strukturen könnten beispielweise, elektro-optische oder akustooptische Elemente umfassen, in welchen der Brechungsindex variiert werden kann, indem ein geeignetes Material elektrischen Feldern oder Ultraschallwellen ausgesetzt wird. Diese Variation des Brechungsindex kann dann dazu verwendet werden, um die gewünschte Ablenkung des Lichts zu erzielen.

Obwohl die vorliegende Erfindung anhand der beigefügten Ausführungsbeispiele detailliert beschrieben worden ist, ist es für den Fachmann klar ersichtlich, dass Abweichungen oder Änderungen im Hinblick auf Weglassen einzelner beschriebener Merkmale und / oder unterschiedliche Kombination der vorgestellten Merkmale möglich sind, ohne den Schutzbereich der beigefügten Ansprüche zu verlassen.

## Patentansprüche

1. Regelvorrichtung, die dazu eingerichtet ist, eine flächige Anordnung von individuell ansteuerbaren Strahlablenkungselementen (28) zu regeln, mit der eine Pupillenfläche eines Beleuchtungssystems einer mikrolithographischen Projektionsbelichtungsanlage variabel ausleuchtbar ist, wobei sich durch jedes Strahlablenkungselement (28) eine Ablenkung eines darauf auftreffenden Projektionslichtbündels (32) in Abhängigkeit von einem an dem Strahlablenkungselement (28) anliegenden Steuersignal erzielen lässt,
aufweisend
a) eine Messeinrichtung, die dazu eingerichtet ist, ein Messsignal zu erzeugen,
die Regelvorrichtung ist **gekennzeichnet durch**
b) einen modelbasierten Zustandsschätzer, der dazu eingerichtet ist, unter Verwendung des Messsignals einen geschätzten Zustandvektor zu bestimmen, der die von dem Strahlablenkungselement (28) hervorgerufene Ablenkung und deren zeitliche Ableitung repräsentiert, und durch
c) einen Regler, der dazu eingerichtet ist,
- den geschätzten Zustandsvektor und einen Sollwert für die von dem Strahlablenkungselement (28) hervorgerufene Ablenkung und deren zeitliche Ableitung zu verarbeiten und
- über eine Stellgröße (s) das an dem Strahlablenkungselement (28) anliegende Steuersignal zu steuern.

2. Regelvorrichtung nach Anspruch 1, **dadurch gekennzeichnet, dass** der modellbasierte Zustandsschätzer dazu eingerichtet ist, einen geschätzten Zustandsvektor mit einem Zeittakt auszugeben, der höher ist als ein Zeittakt, mit dem das Messsignal erzeugt wird.

3. Regelvorrichtung nach Anspruch 1 oder 2, **dadurch gekennzeichnet, dass** der modellbasierte Zustandsschätzer ein Kalman-Filter ist.

4. Regelvorrichtung nach einem der vorhergehenden Ansprüche, **dadurch gekennzeichnet, dass** der Regler drei Proportionalglieder aufweist, mit denen der Einfluss verschiedener Regelanteile bestimmbar ist.

5. Regelvorrichtung nach Anspruch 4, **dadurch gekennzeichnet, dass** der Regler aufweist:
a) ein erstes Proportionalglied, der dazu eingerichtet ist, eine dem Regler zugeführte Regeldifferenz mit einer Konstanten zu multiplizieren,
b) ein zweites Proportionalglied, der dazu eingerichtet ist, ein Ausgangssignal eines Integrierers, der die Regeldifferenz integriert, mit einer Konstanten zu multiplizieren, und
c) ein drittes Proportionalglied, der dazu eingerichtet ist, eine zeitliche Ableitung der Regeldifferenz mit einer Konstanten zu multiplizieren.

6. Regelvorrichtung nach Anspruch 5, **dadurch gekennzeichnet, dass** die der Regler dazu eingerichtet ist, die von dem ersten, dem zweiten und dem dritten Proportionalglied ausgebbaren Regleranteile zu addieren und als die Stellgröße (s) auszugeben.

## Claims

1. Control device configured to control a planar array of individually drivable beam deflection elements (28), by means of which a pupil surface of an illumination system of a microlithographic projection exposure apparatus is illuminateable in a variable manner, wherein each beam deflection element (28) makes it possible to achieve a deflection of a projection light beam (32) incident thereon depending on a control signal present at the beam deflection element (28),
comprising
a) a measuring unit configured to generate a measurement signal,
the control device is **characterized by**
b) a model-based state estimator configured to determine, using the measurement signal, an estimated state vector representing the deflection brought about by the beam deflection element (28) and the time derivative of said deflection, and by
c) a controller configured
- to process the estimated state vector and a setpoint value for the deflection brought about by the beam deflection element (28) and the time derivative of said deflection and
- to control the control signal present at the beam deflection element (28) by way of a manipulated variable (s).

2. Control device according to Claim 1, **characterized in that** the model-based state estimator is configured to output an estimated state vector with a timing clock that is higher than a timing clock with which the measurement signal is generated.

3. Control device according to Claim 1 or 2, **characterized in that** the model-based state estimator is a Kalman filter.

4. Control device according to any of the preceding claims, **characterized in that** the controller comprises three proportional elements, by means of which the implements of different control portions is determinable.

5. Control device according to Claim 4, **characterized in that** the controller comprises:
a) a first proportional element configured to multiply a control difference fed to the controller by a constant,
b) a second proportional element configured to multiply an output signal of an integrator that integrates the control difference by a constant, and
c) a third proportional element configured to multiply a time derivative of the control difference by a constant.

6. Control device according to Claim 5, **characterized in that** the controller is configured to add the controller portions that are able to be output by the first, second and third proportional elements, and to output said added controller portions as the manipulated variable (s).

## Revendications

1. Dispositif de régulation conçu pour commander un agencement plan d'éléments de déviation de faisceau (28) pouvant être commandés individuellement, au moyen desquels une surface pupillaire d'un système d'éclairage d'une installation microlithographique à projection peut être illuminée de manière variable, dans lequel une déviation d'un faisceau lumineux de projection (32) incident sur chaque élément de déviation de faisceau (28) peut être obtenue par ce dernier en fonction d'un signal de commande appliqué à l'élément de déviation de faisceau (28), comportant
a) un dispositif de mesure qui est conçu pour générer un signal de mesure, le dispositif de régulation étant **caractérisé par**
b) un estimateur d'état à base de modèle conçu pour déterminer, en utilisant le signal de mesure, un vecteur d'état estimé qui représente la déviation provoquée par l'élément de déviation de faisceau (28) et sa dérivée temporelle, et par
c) un régulateur qui est conçu pour
- traiter le vecteur d'état estimé et une valeur de consigne pour la déviation provoquée par l'élément de déviation de faisceau (28) et sa dérivée temporelle et
- commander par l'intermédiaire d'une grandeur de réglage (s) le signal de commande appliqué à l'élément de déviation de faisceau (28).

2. Dispositif de régulation selon la revendication 1, **caractérisé en ce que** l'estimateur d'état à base de modèle est conçu pour délivrer un vecteur d'état estimé ayant une horloge supérieure à une horloge avec laquelle le signal de mesure est généré.

3. Dispositif de régulation selon la revendication 1 ou 2, **caractérisé en ce que** l'estimateur d'état à base de modèle est un filtre de Kalman.

4. Dispositif de régulation selon l'une des revendications précédentes, **caractérisé en ce que** le dispositif de régulation comporte trois éléments proportionnels au moyen desquels l'influence des différentes composantes de régulation peut être déterminée.

5. Dispositif de régulation selon la revendication 4, **caractérisé en ce que** le régulateur comprend :
a) un premier élément proportionnel conçu pour multiplier par une constante une différence de régulation fournie au régulateur,
b) un deuxième élément proportionnel conçu pour multiplier par une constante un signal de sortie d'un intégrateur qui intègre la différence de régulation, et
c) un troisième élément proportionnel conçu pour multiplier par une constante une dérivée temporelle de la différence de régulation.

6. Dispositif de régulation selon la revendication 5, **caractérisé en ce que** le dispositif de régulation est conçu pour additionner les composantes de régulation pouvant être délivrées par les premier, deuxième et troisième éléments proportionnels et pour les délivrer en tant que grandeur de réglage (s).
